# EUROPEAN PATENT APPLICATION

(11) **EP 4 498 049 A1**
(43) Date of publication of application: **29.01.2025**
(21) Application number: 23187752.3
(22) Date of filing: 26.07.2023
(51) Int. Cl.: G01J 1/04, G01J 1/12, G01J 3/28, G02B 6/12, G02B 6/42

(54) **AN INTEGRATED DEVICE, AND IMAGING SYSTEM, AND A METHOD FOR WAVELENGTH DEPENDENT DETECTION OF LIGHT**

(71) Applicant: Imec VZW, 3001 Leuven (BE); Katholieke Universiteit Leuven KU Leuven Research & Development, 3000 Leuven (BE)
(72) Inventor: Shramkova, Oksana, 3020 Herent (BE); Gehlaar, Robert, 3020 Herent (BE); Genoe, Jan, 327 Testelt (BE); Figeys, Bruno, 3020 Herent (BE); Ali, Farhan, 3000 Leuven (BE); Mac Ciarnain, Rossa, 3010 Leuven (BE)
(74) Representative: AWA Sweden AB

(57) **Abstract**

There is provided an integrated device for wavelength dependent detection of light, comprising:
a concentrating element comprising a collecting end and a transmitting end, and configured to collect light incident at the collecting end, and to concentrate the light at the transmitting end;
a multimode waveguide forming an extension from a receiving end to a distributing end, and surrounded by a host medium along the extension, wherein the transmitting end is coupled to the receiving end, the waveguide being configured to receive the light from the concentrating element at the receiving end, wherein the waveguide and the host medium are configured to propagate light to form a light pattern at the distributing end, wherein a distribution of the light pattern across the distributing end is dependent on wavelength of the light;
a plurality of light sensitive elements arranged such that different light sensitive elements receive different portions of the light pattern at the distributing end for wavelength dependent detection of light.

## Description

### Technical field

The present description relates to multispectral detection of light, and more specifically to an integrated device, an imaging system, and a method for wavelength dependent detection of light.

### Background

Light detectors and image detectors are essential solid-state components of systems that convert light into electric signals. Especially, detectors for detection of several wavelength bands of light within the ultraviolet, visible, and infrared spectral ranges, have found widespread application ranging from consumer electronic cameras and smartphones, to environmental sensing in automotive and other scientific and industrial applications.

An important device parameter, not least for image detectors, is the spatial resolution, which is linked to the size of the respective light sensitive elements, or pixels. For example, smaller pixels can lead to higher camera resolution. At the same time, since wavelength and absorption length remain constant in spite of the pixel shrinkage, down scaling of the pixels leads to decreased light sensitivity, increased noise, and increased spatial optical cross-talk.

In order to distinguish between light of different wavelength bands, imaging devices such as digital cameras typically comprise filter arrays, such as an absorptive Bayer color-filter array, covering the pixels. A common example is cameras for photography, wherein color filters are integrated on the pixel array, below micro-lenses, to distinguish between different colors. However, due to the absorptive nature of the color filters, about two-thirds of the light entering a pixel is absorbed and lost in the filtering process.

Furthermore, pixel shrinkage requires a reduction in color filter thickness. Decrease of pixel size restricts the effective use of micro-lens arrays, influencing spatial resolution where the pixel size is smaller than the circle of confusion of the micro-lens. Also important are the micro-lens fabrication size limitations and that as the lens diameter approaches the wavelength, the ability of the micro-lens to concentrate and focus light decreases.

Hence, there is a need in the art for further improvements related to light sensitivity and thus to downscaling of light detection devices and imaging devices related to multi-spectral light detection.

### Summary

An objective of the present description is to mitigate, alleviate or eliminate one or more of the above-identified deficiencies in the art and disadvantages singly or in any combination. These and other objectives are at least partly met by the invention as defined in the independent claims. Preferred embodiments are set out in the dependent claims.

According to a first aspect there is provided an integrated device for wavelength dependent detection of light, comprising:
a concentrating element comprising a collecting end and a transmitting end, the concentrating element being configured to collect light incident at the collecting end, and to concentrate the light at the transmitting end;
a waveguide arranged in a host medium, wherein the waveguide is a multimode waveguide and forms an extension from a receiving end to a distributing end, and is surrounded by the host medium along the extension, wherein the transmitting end of the concentrating element is directly coupled to the receiving end of the waveguide, the waveguide being configured to receive the light from the concentrating element at the receiving end, wherein the waveguide and the host medium are configured to propagate the light to form a light pattern at the distributing end, wherein a distribution of the light pattern across an area in the waveguide and the host medium at the distributing end is dependent on wavelength of the light;
a plurality of light sensitive elements arranged such that different light sensitive elements of the plurality of light sensitive elements receive different portions of the light pattern at the distributing end for wavelength dependent detection of light.

By the term "wavelength dependent detection" is here meant detection of light such that information related to the wavelength of the light is detected. Typically, light of different wavelengths propagates along different paths such that different wavelengths are incident onto different light sensitive elements. A single device may be used for wavelength dependent detection of light in a point. It is conceivable that a single device may be used as a standalone device for such detection of light in a point. However, it is equally conceivable that a plurality of devices may be arranged in an array, such as in rows and columns, wherein different devices are configured to detect light at different points in space. By the present arrangement, wavelength dependent imaging may be provided.

In this context the term "light" should be allowed a broad interpretation, not limited to visible electromagnetic radiation. Rather, the term "light" may also include for example ultraviolet light, infrared light, or combinations thereof.

The concentrating element is configured to collect light incident at the collecting end and to propagate the collected light to the transmitting end. The concentrating element is further configured to concentrate the light at the transmitting end. The concentrating element may have a straight shape along the extension from the collecting end to the transmitting end, or the concentrating element may alternatively have a tapered shape or a widening shape along the extension from the collecting end to the transmitting end. By way of example, the concentrating element may be shaped such that the light may be concentrated to a very small area at the transmitting end having a size in the same order of magnitude as the wavelength of the light. By way of example, the transmitting end may have a width of about 340 nm. By way of further example, a width of the collecting end may around 220 nm.

Typically, the cross-section of the concentrating element is in the shape of a square, however it is conceivable that the cross-section of the concentrating element may alternatively be of another shape, such as a rectangular, triangular, circular, or elliptical shape. Thus, the concentrating element in full may have a shape of a cylinder, sphere, half-sphere, cube, pyramid, or any other suitable shape.

The concentrating element may be configured to concentrate the light at the transmitting end, and thus at, or close to, the receiving end of the waveguide. By the present arrangement, the light may be coupled into the waveguide from the concentrating element such that specific modes may be excited in the waveguide.

Given as a non-limiting example, the concentrating element may be in the form of a dielectric micro-element. The concentrating element may be configured to concentrate the light by providing a photonic nano-jet.

It should be understood that the concentrating element may also be arranged in a host medium. The host medium surrounding the concentrating element may be of the same type as the host medium surrounding the waveguide, or it may alternatively be of a different type. As yet another alternative, the concentrating element may be without a host medium arranged around it. In such a case it is conceivable that the concentrating element is instead surrounded by an ambient medium of the environment wherein the device is located. The ambient medium may function as a host medium even though it is not part of the device as such. By way of example, such an ambient medium surrounding the concentrating element may be ambient air.

The waveguide arranged in the host medium is configured to receive the light from the transmitting end of the concentrating element at the receiving end of the waveguide. In order for all light collected at the collecting end to be coupled into the waveguide, the concentrating element is configured such that the transmitting end of the concentrating element has a cross-section that is not larger than the cross-section of the receiving end of the waveguide. Typically, the transmitting end of the concentrating element has a cross-section that is smaller than the cross-section of the receiving end of the waveguide.

The transmitting end of the concentrating element may be directly coupled to the receiving end of the waveguide. The receiving end may be in direct physical contact with the transmitting end. Alternatively, a gap may be formed between the receiving end and the transmitting end. As yet another alternative, the concentrating element and the waveguide may be made of a single piece of material such that the concentrating element and the waveguide are different portions of the single piece.

By way of example, one or more additional layers may be provided between the transmitting end and the receiving end. The one or more additional layers may enhance the coupling of light between the concentrating element and the waveguide.

The waveguide and the host medium are further configured to propagate the light from the receiving end to the distributing end. It should be understood that the distributing end encompasses the end of the waveguide as well as the end of the host medium, such that the waveguide and the host medium form a common area of the distributing end.

The waveguide may be, but is not required to be, tapered from the receiving end to the distributing end such that a cross-section of the receiving end is larger than a cross-section of the distributing end. Alternatively, the sides of the waveguide may be parallel.

As the waveguide is a multimode waveguide, the waveguide may propagate the light through the waveguide in dependence of wavelength. Put differently, in the multimode waveguide modes with different wavelengths propagate with different beating lengths. By way of example, lower-order modes may propagate inside the waveguide, whereas higher-order modes may penetrate sidewalls of the waveguide into the host medium and may propagate inside the host medium. In this manner, a light pattern is formed at the distributing end. The distribution of the light pattern across the area in the waveguide and the host medium at the distributing end is dependent on the wavelength content of the light.

Given only as an example, incident light of several wavelengths may be propagated through the waveguide and the host medium such that different wavelengths are provided with different spatial distribution of intensity, based on the different modes excited in the waveguide. By the present arrangement, different wavelengths may reach different locations of the distributing end, forming a light pattern at the distributing end. It should, however, be realized that the waveguide and the host medium may not necessarily completely separate different wavelengths to different parts of the light pattern. Rather, the waveguide and the host medium may provide a light pattern in a cross-section of the waveguide and the host medium (such as at the distributing end), wherein the spatial distribution of light is different for different wavelengths. However, it is conceivable that incident light of several wavelengths may, alternatively, be fully separated based on the different modes excited in the waveguide, such that different wavelengths may reach different locations of the distributing end.

Given as a non-limiting example, the waveguide may be made of Si₃N₄ with refractive index varying from 2.0 to 2.1 across the visible spectrum of light, and the dielectric host medium may be made of SiO₂ with refractive index varying from 1.454 to 1.47 across the visible spectrum. Given as further non-limiting examples, materials such as TiOx, NbOx, amorphous Si, or Carbon rich amorphous silicon may be used for the waveguide. It serves to mention that the host medium may alternatively be a gas, such as air. Further, it should be understood that the concentrating element may be made of the same material as the waveguide, or it may be made of a different material.

By the term "light sensitive element" is here meant an element reacting to light impinging onto the element, by generating an electric signal as a response to the light intensity. A plurality of light sensitive elements may be arranged on a detector, configured to allow read-out of the electric signals representing light for image acquisition. Given as non-limiting examples, light sensitive elements may be found on photodiodes, photo-multiplier tubes (PMT), and pixels on image detectors such as charge-coupled devices (CCD) and complementary metal oxide semiconductors (CMOS). By way of example, a plurality of light sensitive elements may be in the form of pixels on a CCD or CMOS detector, but may alternatively comprise a plurality of any other type of light sensitive elements.

By way of example, the plurality of light sensitive elements may be arranged in a plane of the detector. By way of further example, the plane may be a planar surface of the detector.

According to an embodiment, the plurality of light sensitive elements is arranged in rows and columns forming an array of light sensitive elements. Thus, the plurality of light sensitive elements may be arranged in a regular manner. This may facilitate manufacturing of the detector.

Typically, a light sensitive element is in the shape of a square, however it is conceivable that the light sensitive element may alternatively be of another shape, such as a rectangular, circular, or elliptical shape.

However, it should be realized that the plurality of light sensitive elements need not be arranged in a regular manner and that different light sensitive elements may have different sizes and/or shapes.

It should be realized that the waveguide and the host medium may, but is not limited to, separate wavelength bands of incident light onto a light pattern at the distributing end, such that different light sensitive elements may detect different wavelength bands, or colors, of the incident light. Given as a non-limiting example, the wavelength bands may be separated in a Bayer-like pattern onto the plurality of light sensitive elements.

One or more light sensitive elements may be associated with specific wavelength bands. By way of a non-limiting example, if the wavelength bands correspond to red, green, and blue light, the light sensitive elements are associated with red, green and blue wavelength bands, respectively. Further, the combination of red and green may be used to represent the color yellow, and the combination of green and blue may be used to represent the color cyan.

An advantage with the present aspect is that a device for wavelength dependent detection of light may be provided without using conventional color filters. By using color filters a relatively large portion of the collected light may be discarded, since only a specific wavelength band will be transmitted, whereas unwanted wavelength bands may be removed by absorption or reflection by the color filter. By the present inventive concept, most, or preferably all of the collected light may reach the detector, since light is not filtered out of the optical path, but rather redistributed and/or split into different paths based on wavelength. The present arrangement may therefore provide wavelength dependent light detection with higher efficiency and sensitivity.

Another advantage with the present aspect is that wavelength dependent detection of light may be provided with little, or preferably no dependence on polarization of the light. Conventional techniques for wavelength dependent detection may suffer from unwanted polarization dependence which affects the accuracy of the detection. The present arrangement may therefore provide wavelength dependent detection of light with higher accuracy in detection of the different wavelength bands.

According to an embodiment, the light sensitive elements are arranged in a planar fashion in a detection plane,
wherein the device further comprises a symmetry axis extending through a center of the detection plane, in a direction perpendicular to the detection plane, and
wherein the concentrating element and the waveguide, respectively, are symmetrically arranged along the symmetry axis such that the concentrating element, the waveguide, and the plurality of light sensitive elements extend symmetrically from the symmetry axis in two orthogonal directions parallel to the detection plane.

In the present arrangement, the symmetry axis may extend along a main propagation direction of the light. In this respect the symmetry axis may also be regarded as the optical axis of the device.

By way of example, the two orthogonal directions may be the two directions in which the rows and columns of light sensitive elements of the detector are arranged.

The present symmetric arrangement may provide a symmetric light pattern, that is, a symmetric distribution of the light at the distributing end, with respect to wavelength. By way of example, short wavelengths may be closer to the symmetry axis than long wavelengths. By way of further example, blue light may be located in or close to the center of the light pattern at the distributing end, whereas green and red light may be located farther from the center of the light pattern, symmetrically distributed in two orthogonal directions.

An advantage with this embodiment is that this is an easy way of providing wavelength dependent detection of light, which is independent of polarization of the light. The wavelength content, or color, of the light may be easily determined from such a regular and systematic distribution.

According to an embodiment, the waveguide and the host medium are configured to excite modes having a field distribution which is symmetrical with respect to the symmetry axis of the waveguide.

Given as a non-limiting example, the waveguide and the host medium may be configured to excite mode (0,0), representing blue, modes (2,0) and/or (0,2) representing green, and mode (2,2) representing red.

According to an embodiment, the waveguide and the host medium are configured to propagate the light such that a portion of the light is propagated from the waveguide into the host medium, to form part of the light pattern at the distributing end.

An advantage with this embodiment is that a strong separation between different wavelength bands may be provided, thereby reducing cross-talk between wavelength bands and improving signal-to-noise ratio.

According to an embodiment, the waveguide and the host medium are further configured to propagate the light to form the light pattern at the distributing end such that the distribution of the light pattern across the area in the waveguide and the host medium at the distributing end is independent of polarization of the light.

An advantage with this embodiment is that wavelength dependent detection of light with no dependence on polarization of the light may be provided. Conventional techniques for wavelength dependent imaging may suffer from unwanted polarization dependence which affects the accuracy of the detection. The present arrangement may therefore provide wavelength dependent detection of light with higher accuracy in detection of the different wavelength bands.

According to an embodiment, the concentrating element is configured to generate a photonic nano-jet for concentrating the light.

By the term "photonic nano-jet" is here meant a narrow, intense electromagnetic beam. By way of example, a nano-jet may be created by a dielectric microelement with circular cross-section, such as microspheres and microcylinders, focusing light in its proximity, to form such a beam exiting the element on its opposite side. Thus, if the concentrating element comprises a collecting end with a circular cross-section, the light in the proximity of the collecting end may be focused into a nano-jet exiting the concentrating element at the transmitting end.

Typically, the concentrating element is configured such that the nano-jet is positioned along the symmetry axis of the device. However, it serves to mention that as an alternative the nano-jet may be slightly off-set from the symmetry axis of the device. Given as a non-limiting example, the nano-jet may be off-set by 100 nm from the symmetry axis. Such an off-set may still provide a device with polarization independent splitting light.

Further, it is conceivable that the concentrating element may be configured to provide the nano-jet at the boundary of the concentrating element and the waveguide. Alternatively, the concentration element may be configured to provide the nano-jet close to the boundary of the concentrating element and the waveguide, but in either the concentrating element or in the waveguide.

An advantage with this embodiment is that the combination of a multimode waveguide and a nano-jet shows particular advantages in terms of light efficiency, light splitting properties, and spatial resolution.

Another advantage is that the total thicknesses of the stack for wavelength splitting, e.g. waveguide, will be reduced. Further, reduced thickness of the waveguide may lead to a reduced number of fabrication steps, which in turn may lead to a simplified fabrication process. Moreover, the fabrication process of concentrating elements for nano-jets may be less complex compared to the fabrication process of the other light concentrating components.

According to an embodiment, the concentrating element and the waveguide are made of a same material.

An advantage with this embodiment is that the manufacturing process may be simplified. If the concentrating element and the waveguide are made of the same material, it is conceivable that they may be made using the same process, either one directly after the other or even simultaneously.

According to an embodiment, the incident light is incident from a medium having a first refractive index n₁,
wherein the concentrating element and the waveguide are made of a material having a second refractive index n₂,
wherein the host medium is made of a material having a third refractive index n₃, and
wherein the second refractive index n₂ is larger than the first refractive index n₁, and the third refractive index n₃, respectively.

According to an embodiment, the waveguide has a straight shape along the extension from the receiving end to the distributing end, such that a cross-section of the receiving end and a cross-section of the distributing end are of equal size, or wherein the waveguide has a tapered shape along the extension from the receiving end to the distributing end, such that a cross-section of the receiving end is larger than a cross-section of the distributing end.

According to an embodiment, the concentrating element comprises a collecting end configured to collect the incident light, and a transmitting end configured to transmit the concentrated light from the concentrating element to the waveguide, and
wherein a cross-section of the receiving end of the waveguide is larger than a cross-section of the transmitting end of the concentrating element.

According to an embodiment, a cross-sectional width of the receiving end and a cross-sectional width of the distributing end, respectively, are not larger than 1 µm.

According to an embodiment, the device further comprises a spacer element arranged between the distributing end and the plurality of light sensitive elements.

It should be understood that, for some types of detectors to detect light from waveguides separating the light by wavelength, a space between the waveguide and the detector may be needed to improve the detection efficiency. By way of example, this may be the case for Si based detectors.

However, it serves to mention that if for example a thin film detector is used, a spacer element may not necessarily be required. By way of example, this may be the case for Perovskite detectors.

According to an embodiment, the spacer element is a slab waveguide.

An advantage with this embodiment is that it provides an easy manner of manufacturing the spacer element. A planar layer of the material for the spacer element may simply be provided onto the detector, and subsequently the remaining structure of waveguide, host medium, and concentrating element may be provided on top of the spacer element.

According to an embodiment, the distributing end is provided with an anti-reflection coating.

The anti-reflection coating may reduce or even eliminate light reflections back into the waveguide, when the light reaches the distributing end. In other words, most, and possibly all light may be transmitted from the distributing end onto the respective light sensitive elements. The anti-reflection coating may be an impedance equalizer coating. By way of example, the anti-reflection coating may have a thickness of about a quarter of the nominal wavelength of the light.

An advantage with the present arrangement is that light losses are further reduced, and thus efficiency and sensitivity of the light detection of the device is further improved.

According to an embodiment, the device further comprises Deep Trench Isolation, DTI, technology such that each respective light sensitive element is confined by a trench preventing light incident onto the light sensitive element from propagating to adjacent light sensitive elements.

If the light incident onto the plurality of light sensitive elements is allowed to propagate a significant distance, as for example more than 500 nm, the light may spread over several adjacent light sensitive elements causing cross-talk between the light sensitive elements. If this happens, the spatial separation of the light provided by the waveguides and host medium is lost. In order to prevent cross-talk, a confinement around the respective light sensitive elements may be used. DTI effectively functions as out-of-plane silicon waveguides, in which light gets trapped due to total internal reflection.

An advantage with this embodiment is that cross-talk may be efficiently reduced, and possibly avoided. This leads to improved signal-to-noise ratio of the light detection, which in turn leads to improved accuracy of measurement results of wavelength content in the incident light.

According to an embodiment, the DTI is further arranged in the spacer element.

However, in case the device does not comprise a spacer element, it is conceivable that the DTI may be further arranged onto the detector.

According to an alternative embodiment, the DTI is further arranged in between the spacer element and the plurality of light sensitive elements.

An advantage with this embodiment is that cross-talk may be further reduced, and thus light detection performance improved.

According to a second aspect there is provided an imaging system for wavelength dependent imaging, the imaging system comprising an array of devices according to any one of the preceding claims.

It is conceivable that the array of devices are arranged in rows and columns, wherein different devices are configured to detect light at different points in space. By the present arrangement, wavelength dependent imaging may be provided. In the manner described above, each device may represent a picture element, such that each device respectively corresponds to a spatial position in an imaged scene, and wherein each picture element comprises information related to the wavelength content of the light, from the corresponding spatial position.

It should be understood that the imaging system may comprise a large imaging detector with enough light sensitive elements to provide all the plurality of light sensitive elements for all devices in such an array. Thus, the plurality of light sensitive elements of a specific device does not necessarily have to be physically separated from the plurality of light sensitive elements of an adjacent device but may instead form part of the larger imaging detector.

An advantage with the present aspect is that an imaging system for wavelength dependent imaging may be provided without using conventional color filters. By the present inventive concept, most, or preferably all of the collected light may reach the imaging detector, since light is not filtered out of the optical path, but rather redistributed and/or split into different paths based on wavelength for each picture element. The present arrangement may therefore provide wavelength dependent imaging with higher efficiency and sensitivity.

Another advantage with the present aspect is that wavelength dependent imaging may be provided with little, or preferably no dependence on polarization of the light. Conventional techniques for wavelength dependent imaging may suffer from unwanted polarization dependence which affects the accuracy of the light detection. The present arrangement may therefore provide wavelength dependent imaging with higher accuracy in detection of the different wavelength bands.

According to an embodiment, at least some of the light sensitive elements of the plurality of light sensitive elements in each device are shared between different devices, such that at least some of the light sensitive elements are arranged to receive light from distributing ends of at least two adjacent devices.

The present arrangement allows for light sensitive elements of the same size to be used for the different wavelength bands. Due to the symmetry of the devices, and thus to the symmetry of the light pattern at the distributing end, adjacent devices may have the same wavelengths or wavelength bands at the sides or corners of the devices facing each other. Put differently, a side of a device having a certain wavelength band distributed towards that side may be facing a side of an adjacent device towards which the same wavelength band is distributed in the adjacent device. Thus, the sides and corners of the devices facing each other will provide matching wavelength bands, respectively.

This symmetry allows for the devices to share light sensitive elements, since a shared light sensitive element will receive light of the same wavelength band from the different devices that share the light sensitive element. By this arrangement, light sensitive elements may be shared between different devices without having different wavelength bands mix on the shared light sensitive elements.

An advantage with this embodiment is that since the light sensitive elements may be shared between adjacent devices without mixing of wavelength bands occurring on the shared light sensitive elements, the devices may be arranged close to each other, without any gaps in between. This in turn allows for all the light sensitive elements of the detector to be utilized, without leaving light sensitive elements unused in between adjacent devices. Thus, by the present arrangement an imaging system for wavelength dependent imaging with a high spatial resolution may be provided.

According to a third aspect there is provided a method for wavelength dependent detection of light, the method comprising:
collecting, by a concentrating element, light incident at a collecting end of the concentrating element;
concentrating the light at a transmitting end of the concentrating element;
receiving, by a waveguide arranged in a host medium, the light from the concentrating element at a receiving end, wherein the waveguide is a multimode waveguide and forms an extension from the receiving end to a distributing end, and is surrounded by the host medium along the extension, and wherein the transmitting end of the concentrating element is directly coupled to the receiving end of the waveguide;
propagating, by the waveguide and the host medium, the light to form a light pattern at the distributing end, wherein a distribution of the light pattern across an area in the waveguide and the host medium at the distributing end is dependent on wavelength of the light;
receiving different portions of the light pattern at the distributing end at different light sensitive elements of a plurality of light sensitive elements, for wavelength dependent detection of light.

Effects and features of the second and third aspects are largely analogous to those described above in connection with the first aspect. Embodiments mentioned in relation to the first aspect are largely compatible with the second and third aspects. It is further noted that the inventive concepts relate to all possible combinations of features unless explicitly stated otherwise.

Other objectives, features and advantages of the present inventive concept will appear from the following detailed disclosure, from the attached claims as well as from the drawings.

### Brief descriptions of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1A illustrates a two-dimensional projection of an integrated device for wavelength dependent detection of light.
Fig. 1B illustrates a three-dimensional perspective view of the device for wavelength dependent detection of light.
Figs 1C schematically illustrates a top view of the detection plane of the detector with the plurality of light sensitive elements.
Fig. 1D illustrates a set of examples of light transmission of the distributing end, and the light intensity distributions detected by an array of light sensitive elements, for incident light with known wavelength content.
Fig. 2 illustrates detected light intensity at the different light sensitive elements representing blue, green and red light, for four different linear polarizations of incident light.
Fig. 3A schematically illustrates an integrated device for wavelength dependent detection of light, further comprising a spacer element and an anti-reflection coating.
Fig. 3B schematically illustrates the integrated device optionally provided with Deep Trench Isolation, DTI, technology.
Fig. 4A schematically illustrates an imaging system for wavelength dependent imaging.
Figs 4B schematically illustrates a top view of the detection plane of the detector of the imaging system.
Fig. 5 illustrates a schematic block diagram shortly summarizing the method for wavelength dependent detection of light.

### Detailed description

In cooperation with attached drawings, the technical contents and detailed description of the present inventive concept are described thereinafter according to a preferable embodiment, being not used to limit the claimed scope. This inventive concept may be embodied in many different forms and should not be construed as limited to the embodiments set forth herein; rather, these embodiments are provided for thoroughness and completeness, and fully convey the scope of the inventive concept to the skilled person.

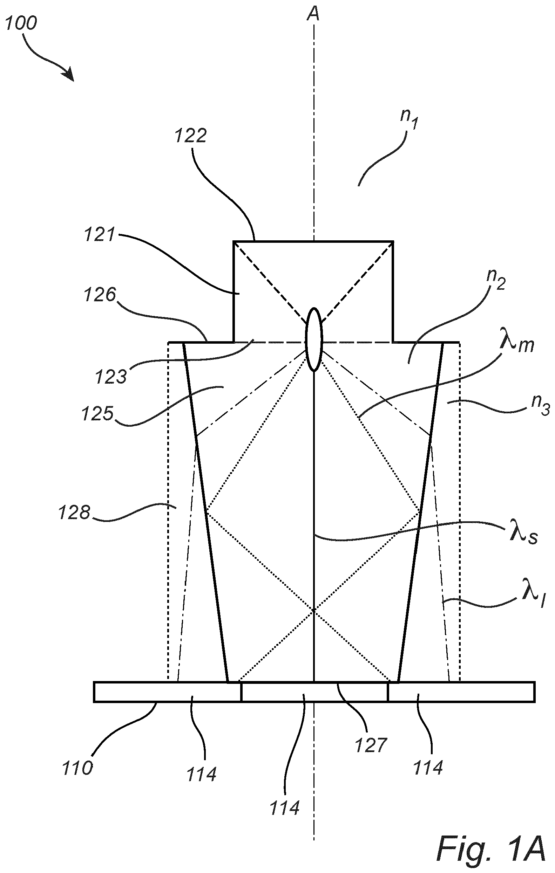

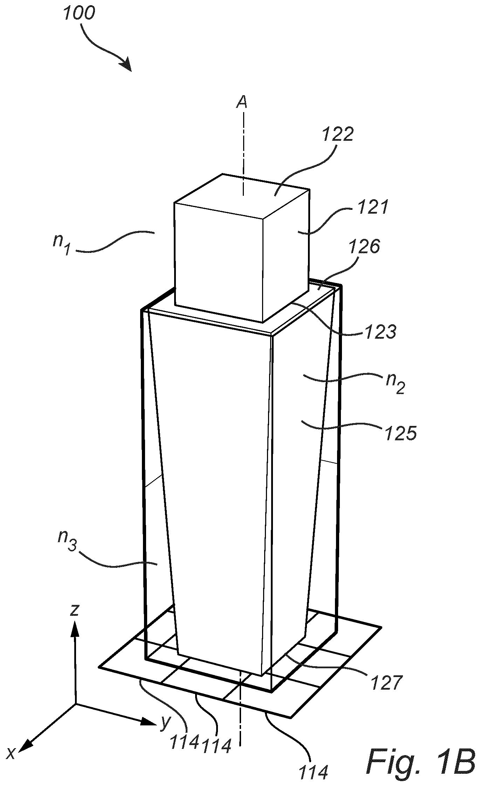

Figs 1A and 1B schematically illustrate an integrated device 100 for wavelength dependent detection of light. Fig. 1A illustrates a two-dimensional projection of the device 100, whereas Fig. 1B illustrates a three-dimensional perspective view of the same.

The device 100 comprises a concentrating element 121 having a collecting end 122 and an opposite transmitting end 123. The concentrating element 121 is configured to collect light incident at the collecting end 122. The light may come from an object or a scene being focused by a lens (not shown here) onto the planar surface of collecting end 122, however also other arrangements directing light onto the collecting end 122 are conceivable. The incident light may be incident from a medium having a first refractive index n₁. By way of example, this medium may be ambient air.

The concentrating element 121 is further configured to propagate the light from the collecting end 122 to the transmitting end 123, such that the light is concentrated at the transmitting end 123. In the present example, concentration of light is provided by the concentrating element 121 being configured to generate a photonic nano-jet. The light in the proximity of the collecting end 122 may be focused into a nano-jet beam exiting the concentrating element 121 at the transmitting end 123.

As illustrated in Fig. 1A-1B, the concentrating element 121 has a straight shape such that the cross-section of the collecting end 122 and the cross-section of the transmitting end 123 are of equal width. However, it is conceivable that the concentrating element 121 alternatively has a tapered or widening shape such that the cross-section of the collecting end 122 and the cross-section of the transmitting end 123 are of different widths.

The device 100 further comprises a waveguide 125 arranged in a host medium 128. The waveguide 125 forms an extension from a receiving end 126 to an opposite distributing end 127. Typically, the receiving end 126 and the distributing end 127 respectively form planar surfaces. Along the extension, the waveguide 125 is surrounded by the host medium 128. However, at the receiving end 126 and distributing end 127, the waveguide is not surrounded by the host medium 128. Instead, the waveguide 125 is arranged such that the receiving end 126 is facing the transmitting end 123 of the concentrating element 121. The waveguide 125 may be arranged such that the receiving end 126 is directly coupled to the transmitting end 123 of the concentrating element 121. Alternatively, the waveguide 125 may be arranged such that a gap is formed between the receiving end 126 and the transmitting end 123.

It serves to mention that, alternatively the concentrating element 121 may be surrounded by a host medium also surrounding the transmitting end 123. In such a case the host medium of the concentrating element 121 may cover also the receiving end 126 of the waveguide 125. By way of example, the host medium of the concentrating element may be the same host medium 128 as for the waveguide 125, or it may be a different host medium having a different refractive index.

As illustrated in Fig. 1A-1B, the waveguide 125 has a tapered shape along the extension from the receiving end 126 to the distributing end 127, such that the cross-section of the receiving end 126 is larger than the cross-section of the distributing end 127. It is conceivable however, that the waveguide 125 may alternatively have a straight shape along the extension from the receiving end 126 to the distributing end 127, such that the cross-section of the receiving end 126 and the cross-section of the distributing end 127 are of equal size.

The waveguide 125 may be made of a material having a second refractive index n₂. The host medium 128 may be made of a material having a third refractive index n₃. By way of example, the refractive indexes may be chosen such that the second refractive index n₂ is larger than the first refractive index n₁, and the third refractive index n₃, respectively. In the present example, the concentrating element 121 and the waveguide 125 are made of a same material. Thus, in the present example, also the concentrating element 121 is made of a material having a second refractive index n₂. However, it is conceivable that the concentrating element 121 and the waveguide 125 are alternatively made of different materials having different refractive indexes.

The waveguide 125 is configured to receive the light from the transmitting end 123 of the concentrating element 121, at the receiving end 126. Most of the light, and preferably all the light, collected at the collecting end 122 of the concentrating element 121 may be coupled into the waveguide 125 via the receiving end 126. In order to allow all the light in the concentrating element 121 to be coupled into the waveguide 125, the cross-section of the receiving end 126 of the waveguide 125 is typically larger than the cross-section of the transmitting end 123 of the concentrating element 121.

Optionally, one or more additional layers may be provided between transmitting end 123 and the receiving end 126. The one or more additional layers may enhance the coupling of light between the concentrating element 121 and the waveguide 125.

The waveguide 125 and the host medium 128 are configured to propagate the light from the receiving end 126 to the distributing end 127. As the waveguide 125 is a multimode waveguide, propagating of light through the waveguide 125 is dependent on wavelength of the light. Light with different wavelengths may therefore take different directions to form a light pattern at the distributing end 127.

The waveguide 125 and the host medium 128 are configured to propagate the light such that a portion of the light is propagated from the waveguide 125 into the host medium 128, to form part of the light pattern at the distributing end 127. As illustrated in Fig. 1A, light with the shortest wavelengths λₛ may propagate at or close to the symmetry axis A, such that this light exits at or close to the center of the distributing end 127. The mid-range wavelengths λₘ may be guided by the waveguide by internal reflection at the boundary between the waveguide 125 and the host medium 128, and remain in the waveguide 125 until exiting the waveguide 125 at the distributing end 127. The longest wavelengths λₗ may penetrate the waveguide 125 sidewalls at the boundary between the waveguide 125 and the host medium 128 to continue propagation through the host medium 128 until exiting the host medium 128 at the distributing end 127.

As a result, the distribution of the light pattern across an area in the waveguide 125 and the host medium 128 at the distributing end 127 is dependent on wavelength of the light.

In order to detect the intensity of light at different wavelengths or different wavelength bands, a detector 110 is arranged at the distributing end 127. The detector 110 comprises a plurality of light sensitive elements 114 arranged in a planar fashion in a detection plane. The detection plane is typically arranged in parallel with the plane of the distributing end 127. The symmetry axis A extends through the center of the detection plane, in a direction perpendicular to the detection plane. Further, the concentrating element 121 and the waveguide 125, respectively, are symmetrically arranged along the symmetry axis A such that the concentrating element 121, the waveguide 125, and the plurality of light sensitive elements 114 extend symmetrically from the symmetry axis A in two orthogonal directions parallel to the detection plane.

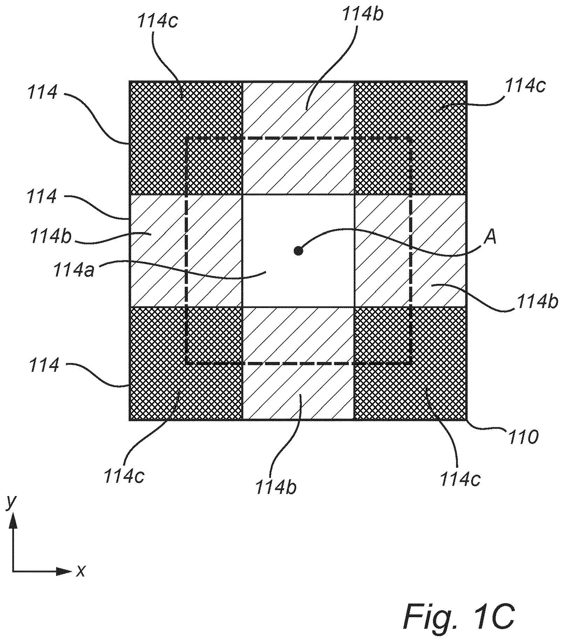

Figs 1C schematically illustrates a top view of the detection plane of the detector 110 with the plurality of light sensitive elements 114. In the present example, the plurality of light sensitive elements 114 is arranged in rows and columns forming an array of light sensitive elements 114. The dashed line corresponds to a planar projection of the full width of the waveguide 125 and the host medium 128 together, onto the detection plane. Note that the width of this unit as represented by the dashed line may be wider than the receiving end 126 of the waveguide, since it may be filled out by the host medium 128. This is illustrated for example in Figs 1A-1B.

The two orthogonal directions in which the detector 110, waveguide 125 and concentrating element 121 are symmetrically arranged around the symmetry axis A, are the two directions in which the rows and columns of light sensitive elements 114 of the detector 110 are arranged. These two directions are here denoted x and y, respectively.

The plurality of light sensitive elements 114 are arranged with respect to the waveguide 125 and the host medium 128 such that different light sensitive elements 114 receive different portions of the light pattern at the distributing end 127. The different wavelength bands are illustrated with a lighter or darker shading, depending on light wavelengths within the respective wavelength bands, relative to each other. A lighter shading represents shorter wavelengths and a darker shading represents longer wavelengths.

As illustrated in Fig. 1C, the shortest wavelengths of the light are incident onto the central light sensitive element 114a of the arrangement, thus close to the symmetry axis A. Farther from the symmetry axis A, the mid-range of the wavelengths are incident onto the light sensitive elements 114b, at or close to the edges of the of the waveguide/host medium 125, 128 arrangement. Even further from the symmetry axis A, the longest wavelengths of the light are incident onto the light sensitive elements 114c, at the corners of the waveguide/host medium 125, 128 arrangement.

By way of example, the wavelength band with the shortest wavelengths may correspond to the color blue, the wavelength band with the mid-range wavelengths may correspond to the color green, and the wavelength band with the longest wavelengths may correspond to the color red. However, it should be understood that wavelength bands may alternatively represent different wavelengths or colors, and may further comprise wavelengths outside the visible part of the spectrum, such as ultraviolet light or infrared light.

By the present arrangement, wavelength dependent detection of light may be provided. The symmetry of the arrangement provides symmetry also in how the different wavelength bands are distributed around the symmetry axis A.

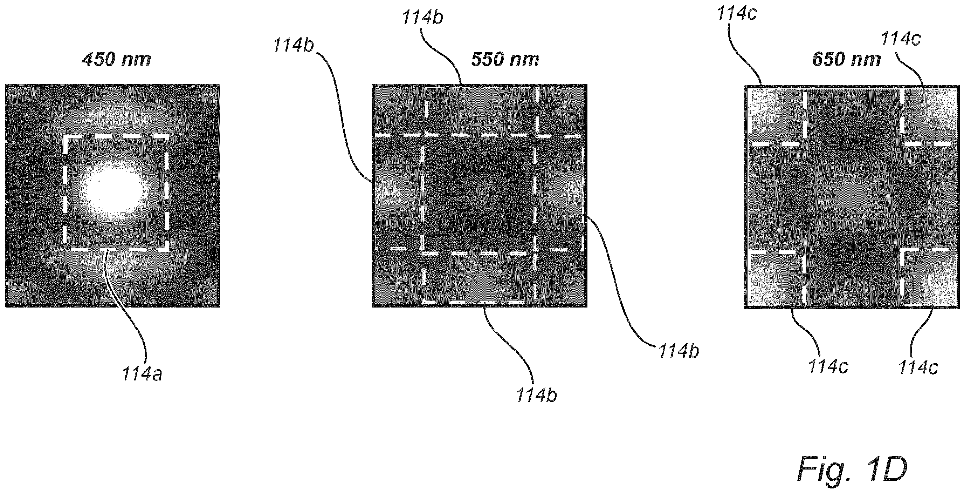

Fig. 1D illustrates a set of examples of light transmission of the distributing end, and the light intensity distributions detected by an array of light sensitive elements 114, for incident light with known wavelength content. Only the portions of the light sensitive elements 114 that are arranged below the waveguide and the host medium are shown. Thus, the corner and side light sensitive elements are truncated, and only the center light sensitive element is shown in full. Grey levels represent the power distribution.

In the left illustration of Fig. 1D, the characteristic light pattern is shown resulting from incident light being purely blue, and in the present example the wavelength of the light is 450 nm. As mentioned also in relation to Fig. 1C, most of the light at this wavelength is incident onto the center light sensitive element 114a of the of the waveguide/host medium arrangement.

In the center illustration of Fig. 1D, the characteristic light pattern is shown resulting from incident light being purely green, and in the present example the wavelength of the light is 550 nm. As mentioned also in relation to Fig. 1C, most of the light at this wavelength is incident onto the light sensitive elements 114b at the edges of the of the waveguide/host medium arrangement.

In the right illustration of Fig. 1D, the characteristic light pattern is shown resulting from incident light being purely red, and in the present example the wavelength of the light is 650 nm. As mentioned also in relation to Fig. 1C, most of the light at this wavelength is incident onto the light sensitive elements 114c at the corners of the of the waveguide/host medium arrangement.

Thus, the symmetry of the arrangement provides symmetry also in how the different wavelength bands are distributed around the symmetry axis A. In other words, the waveguide and the host medium are configured to excite modes having a field distribution which is symmetrical with respect to the symmetry axis of the waveguide.

In the present example, Si₃N₄ was used as material with refractive index n₂, which varies from 2.0 to 2.1 across visible spectrum. SiO₂ was used as dielectric host medium with refractive index n₃, which varies from 1.454 to 1.47 across visible spectrum. Further, in the present example, the refractive index n₁=1.

The present example shows that with the symmetry of the light pattern, a symmetrical Bayer-like pattern of the light sensitive elements may be used for detection.

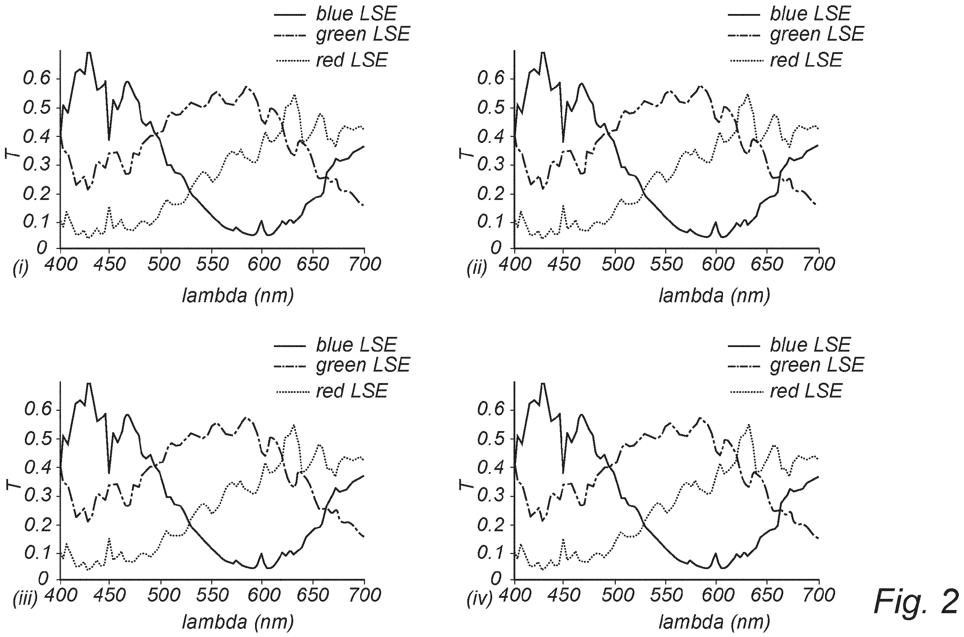

Fig. 2 illustrates detected light intensity at the different light sensitive elements representing blue, green and red light, for four different linear polarizations of incident light.

A typical problem with the prior art is that the light detected at the different wavelength bands may be dependent not only on wavelength but also on polarization of the light. This introduces errors in the measurements of light.

However, with the present arrangement the waveguide and the host medium are further configured to propagate the light to form the light pattern at the distributing end such that the distribution of the light pattern across the area in the waveguide and the host medium at the distributing end is independent of polarization of the light.

In Fig. 2, transmission (T) for the full visible spectrum at normal plane wave incidence measured below the distributing end for the device 100 is illustrated, for four different polarization angles (i) 0°, (ii) 15°, (iii) 45°, and (iv) 90°. It is seen that the detected light transmissions at different wavelengths for the three groups of light sensitive elements, respectively, is substantially the same for all four polarization directions. Thus, the response of the device is practically polarization independent. The polarization independence is due to the symmetry of the device and of the positions of the respective light sensitive elements of the detector, described in relation to preceding figures.

It serves to mention that the transmission results illustrated in Fig. 2 is related to the device 100, however, measurements of the transmission for any device disclosed in the present description would show equivalent results.

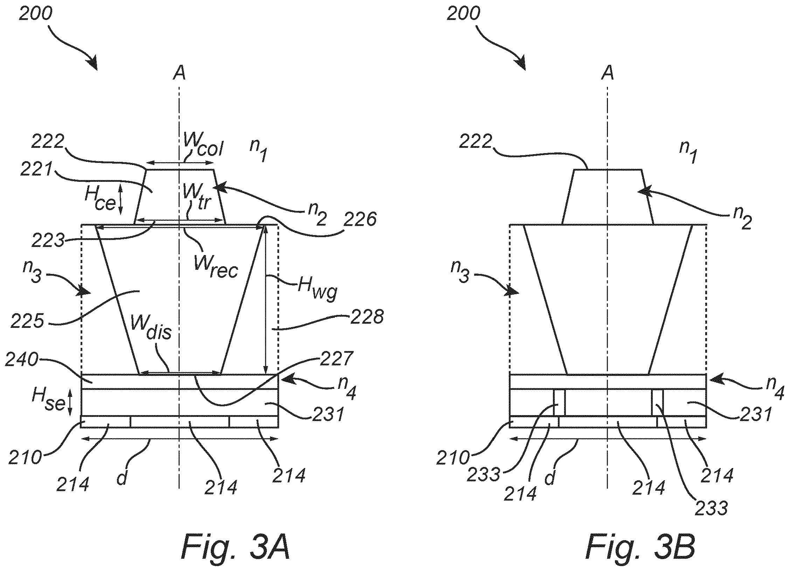

Fig. 3A schematically illustrates an integrated device 200 for wavelength dependent detection of light. Device 200 shares some of the features with device 100 described in relation to Figs 1A-1D, the details of which are not repeated here.

The device 200 comprises a concentrating element 221 having a collecting end 222 and an opposite transmitting end 223. As illustrated in Fig. 3A, the concentrating element 221 has a widening shape such that the transmitting end 223 is larger than the cross-section of the collecting end 222. In the present example, the cross-section of the collecting end 222 has a width of W_{col} = 220 nm, and the cross-section of the transmitting end 223 has a width of Wₜᵣ = 340 nm. The height of the concentrating element 221 is H_{ce} = 620 nm, in the present example. Using a concentrating element 221 with a widening shape, instead of a concentrating element with straight shape and parallel sides, provides an additional degree of freedom in the control of the concentration of the light, as for example of a nano-jet beam. By way of example, the present arrangement may provide more efficient light concentration for inclined light incidence. In this manner, the response of the device may be less dependent on the angle of incidence of the light.

The device 200 further comprises a waveguide 225 arranged in a host medium 228. The waveguide 225 forms an extension from a receiving end 226 to an opposite distributing end 227. The waveguide 225 has a tapered shape such that the cross-section of the waveguide 225 at the receiving end 226 is larger than the cross-section of the waveguide 225 at the distributing end 227. In the present example, the cross-section of the waveguide 225 at the receiving end 226 has a width of W_{rec} = 700 nm, and the cross-section of the waveguide 225 at the distributing end 227 has a width of W_{dis} = 420 nm. The height of the waveguide 225 is H_{wg} = 1.7 µm, in the present example. Using a waveguide 225 with a tapered shape, instead of a waveguide with a straight shape with parallel sides, provides an additional degree of freedom on the control of the beating length of the excited modes. By way of example, by changing the angle of the tapered sides, the height at which light may penetrate through the waveguide 225 side walls may be controlled. In this manner, the light pattern may be controlled, and cross-talk may be reduced.

The waveguide 225 may be made of a material having a second refractive index n₂. In the present example, the concentrating element 221 and the waveguide 225 are made of a same material, thus having a second refractive index n₂. However, it is conceivable that the concentrating element 221 and the waveguide 225 are alternatively made of different materials having different refractive indexes. Further, the host medium 228 may be made of a material having a third refractive index n₃.

The device 200 further comprises a spacer element 231 arranged between the distributing end 227 and the plurality of light sensitive elements 214 of the detector 210. The purpose of the spacer element 231 is to provide a suitable distance between the distributing end 227 and the light sensitive elements 214. A spacer element 231 may be provided with a height that improves the detection efficiency. By way of example, this may be required for Si based detectors. In the present example, the spacer element may have a height of Hₛₑ = 450 nm. The full width of the waveguide 225 and host medium 228 arrangement may be d = 0.8 µm. The width of each light sensitive element 214 may be 400 nm. Given as a non-limiting example, the spacer element 231 may be made of a material with a refractive index n₅. The refractive index n₅ may be different from any of the other refractive indexes mentioned in the device 200, or it may alternatively be equal to one of the other refractive indexes mentioned in the device 200.

As illustrated in Fig. 3A, the spacer element 231 is essentially a slab waveguide. However, contrary to conventional use of a slab waveguide, where light propagates inside the slab waveguide along the extension of the slab, in the present arrangement light propagates across the extension of the slab waveguide. That is, light from the distributing end 227 crosses the slab waveguide to reach the light sensitive elements 214 of the detector 210.

The distributing end 227 is further provided with an anti-reflection coating 240. The purpose of the anti-reflection coating is to reduce or eliminate light reflection back into the waveguide 225 and/or host medium 228. By the present arrangement, most, and possibly all light may be transmitted from the distributing end 227 across the spacer element 231 and onto the respective light sensitive elements 214. The arrangement further improves the efficiency and sensitivity of the light detection of the device 200.

It serves to mention that all dimension mentioned in relation to device 200 are merely examples, and are not in any way limiting to the invention. Further, it serves to mentions that any dimension mentioned in relation to device 200 may be applicable also for device 100.

Fig. 3B schematically illustrates the integrated device 200 which has been optionally provided with Deep Trench Isolation, DTI, technology.

At normal incidence of the light, thus an angle of incidence of the light perpendicular to the surface of the collecting end 222, transmission of light through the arrangement to the light sensitive elements 214 of the detector 210 is high. However, for some arrangements an increasing angle of incidence of the light may cause a reduction of power transmitted through the waveguide arrangement. Further, cross-talk of the different wavelength bands reaching the different light sensitive elements 214 may increase.

To suppress cross-talk, a number of different measures may be taken. By way of example, cross-talk may be suppressed by arranging color filters above the light sensitive elements 214, reducing the size of the light sensitive elements 214, or by providing absorptive layers above the light sensitive elements 214.

Yet another alternative in order to suppress cross-talk, is to provide a Deep-Trench Isolation (DTI) 233 structure at the detector 210. By providing the device 200 with DTI 233 technology, each respective light sensitive element 214 is confined by a trench preventing light incident onto the light sensitive element 214 from propagating to adjacent light sensitive elements 214. As illustrated in Fig. 3B, the DTI 233 may optionally be arranged in the spacer element 231. By providing deep trenches 233 filled with a material having a lower refractive index compared to the material of the spacer element 231, reduced cross-talk and thus lower interference between adjacent light sensitive elements 214 may be provided.

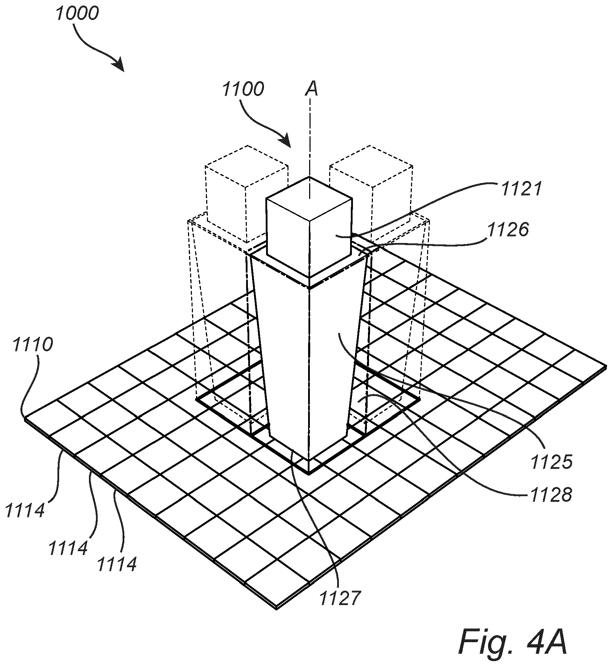

Fig. 4A schematically illustrates an imaging system 1000 for wavelength dependent imaging. The imaging system 1000 comprises an array of devices 1100 for wavelength dependent detection of light. In the present example, devices 1100 are illustrated as being of the same type as the device 100 described in relation to Figs 1A-1D. However, it should be realized that the devices 1100 may be devices of any type disclosed in the present description, such as for example device 200 described in relation to Figs 3A-3B.

The array of devices 1100 may form a fully integrated imaging system 1000 as illustrated in Fig. 4A. However, as an alternative it is conceivable that the array of devices 1100 may be formed of individual devices 1100 arranged adjacent to one another.

The imaging system 1000 comprises a detector 1110 comprising an array of light sensitive elements 1114, arranged in rows and columns in a planar surface of the detector 1110. Each light sensitive element 1114 is configured to generate an electrical signal dependent on the intensity of light incident onto the light sensitive element 1114.

As illustrated in Fig. 4A, the imaging system 1000 comprises a large imaging detector 1110 with enough light sensitive elements 1114 to provide all the light sensitive elements 1114 for all devices 1100. Thus, the light sensitive elements 1114 of a specific device 1100 is not physically separated from the light sensitive elements 1114 of adjacent devices 1100 but instead form part of the larger imaging detector 1110.

On top of the array of light sensitive elements 1114, an array of waveguides 1125 are arranged in a host medium 1128. In the present arrangement, the host medium may extend between the waveguides 1125 of the array, without leaving any gaps in the host medium between adjacent devices 1100. At the receiving end 1126 an array of concentrating elements 1121 are arranged, as previously described. For clarity only three concentrating elements 1121 and waveguides 1125 are illustrated, however it should be understood that in a practical embodiment the array of light sensitive elements 1114 is fully covered, or at least mostly covered, by the array of waveguides 1125 and host medium 1128.

As illustrated in Fig. 4A, the array of concentrating elements 1121 and waveguides 1125 are arranged in rows and columns, such that different devices 1100 may detect light at different points in space. Each device 1100 is configured to propagate light to form a light pattern at the distributing end 1127, dependent on wavelength of the light from the specific point in space, as previously described. By the present arrangement, wavelength dependent imaging may be provided. In the manner described above, each device 1100 may represent a picture element, such that each device respectively corresponds to a spatial position in an imaged scene, and wherein each picture element comprises information related to the wavelength content of the light, from the corresponding spatial position.

It serves to mention that in case an optional DTI is provided to the devices 1100, as previously described cross-talk between different light sensitive elements within respective devices 1100 may be reduced. However, an additional advantage of a DTI applied in the imaging system 1000 is that cross-talk between light sensitive elements of adjacent devices 1100 may be reduced as well. This leads to improved signal-to-noise ratio of the light detection, which in turn leads to improved accuracy of measurement results of wavelength content in the incident light. Ultimately, this leads to improved image quality of the imaging device 1000.

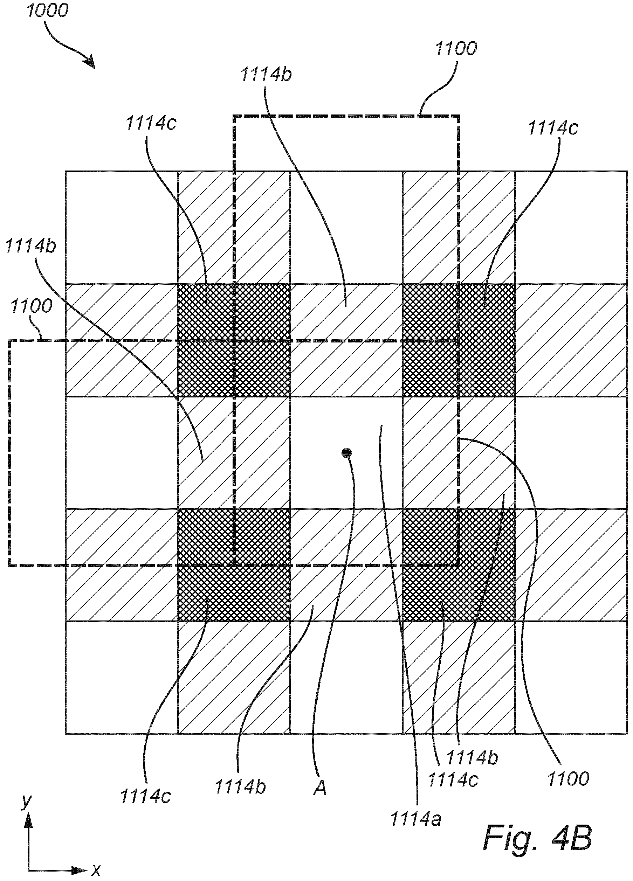

Figs 4B schematically illustrates a top view of the detection plane of the detector 1110 with the plurality of light sensitive elements 1114. The dashed line corresponds to a planar projection of the full width of the waveguide 1125 with host medium 1128 together, for each of the three devices 1100, also illustrated in Fig. 4A. Thus, the two orthogonal directions in which the detector 1110, waveguides 1125 and concentrating elements 1121 are symmetrically arranged around the symmetry axis A, are the two directions in which the rows and columns of light sensitive elements 1114 of the detector 1110 are arranged. These two directions are here denoted x and y, respectively.

For each device 1100, the plurality of light sensitive elements 1114 are arranged with respect to the waveguide 1125 and the host medium 1128 such that different light sensitive elements 1114 receive different portions of the light pattern at the distributing end 1127. The different wavelength bands are illustrated such that a lighter shading represents shorter wavelengths and a darker shading represents longer wavelengths.

For each device 1100, the shortest wavelengths of the light are incident onto the central light sensitive element 1114a of the arrangement, the mid-range of the wavelengths are incident onto the light sensitive elements 1114b at the edges, and the longest wavelengths are incident onto the light sensitive elements 114c, at the corners of the waveguide/host medium 1125, 1128 arrangement.

As illustrated in Fig. 4B, some of the light sensitive elements 1114b, 1114c in each device 1100 are shared between different devices 1100. Put differently, some of the light sensitive elements 1114b, 1114c are arranged to receive light from distributing ends 1127 of at least two adjacent devices 1100.

As described also in relation to preceding figures, the wavelength bands detected by the light sensitive elements 1114a, 1114b, 1114c may correspond to blue, green and red light, respectively. Thus, in the present arrangement, each of the light sensitive elements 1114b detecting green light may be shared between two adjacent devices 1100. Due to the symmetry of the light pattern at the distributing end, the sides of the devices 1100 facing each other will provide matching wavelength bands. Therefore, light sensitive elements 1114b may be shared between different devices 1100 without having different wavelength bands mix on the shared light sensitive elements 1114b. Further, each of the light sensitive elements 1114c detecting red light may be shared between four adjacent devices 1100. Again, due to the symmetry of the light pattern at the distributing end, the corners facing each other will provide matching wavelength bands, and may therefore share light sensitive elements 1114c between different devices 1100 without mixing of different wavelength bands. In the present arrangement, the light sensitive elements 1114a detecting blue light are not shared between different devices 1100, but is unique to each device 1100.

Since the light sensitive elements 1114b, 1114c may be shared between adjacent devices 1100 without mixing of wavelength bands occurring on the shared light sensitive elements 1114b, 1114c, the devices 1100 may be arranged in a compact manner, without any gaps therebetween. Thus, an imaging system 1000 for wavelength dependent imaging with a high spatial resolution may be provided.

It should be realized that the sharing of light sensitive elements 1114 between adjacent devices is presented here only as a non-limiting example. It is equally conceivable that, as an alternative, none of the light sensitive elements 1114 are shared, but are instead unique to each respective device 1100.

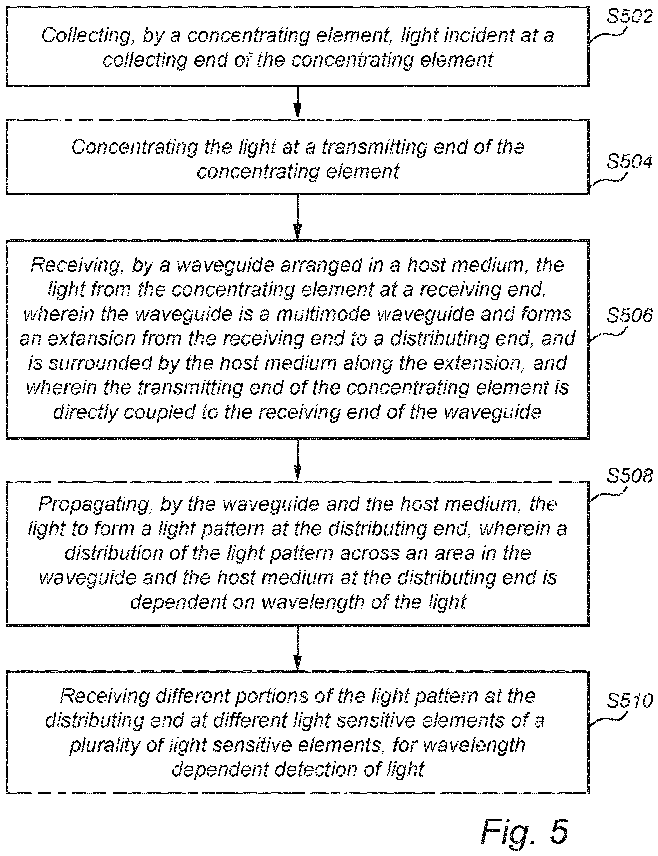

Fig. 5 illustrates a schematic block diagram shortly summarizing the method for wavelength dependent detection of light. It should be understood that the steps of the method, although listed in a specific order herein, may be performed in any order suitable.

The method may comprise collecting S502, by a concentrating element, light incident at a collecting end of the concentrating element.

The method may comprise concentrating S504 the light at a transmitting end of the concentrating element.

The method may comprise receiving S506, by a waveguide arranged in a host medium, the light from the concentrating element at a receiving end. The waveguide is a multimode waveguide and forms an extension from the receiving end to a distributing end, and is surrounded by the host medium along the extension. The transmitting end of the concentrating element is directly coupled to the receiving end of the waveguide.

The method may comprise propagating S508, by the waveguide and the host medium, the light to form a light pattern at the distributing end. A distribution of the light pattern across an area in the waveguide and the host medium at the distributing end is dependent on wavelength of the light.

The method may comprise receiving S510 different portions of the light pattern at the distributing end at different light sensitive elements of a plurality of light sensitive elements, for wavelength dependent detection of light.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. An integrated device (100, 200, 1100) for wavelength dependent detection of light, comprising:
a concentrating element (121, 221, 1121) comprising a collecting end (122, 222) and a transmitting end (123, 223), the concentrating element (121, 221, 1121) being configured to collect light incident at the collecting end (122, 222), and to concentrate the light at the transmitting end (123, 223);
a waveguide (125, 225, 1125) arranged in a host medium (128, 228, 1128), wherein the waveguide (125, 225, 1125) is a multimode waveguide and forms an extension from a receiving end (126, 226, 1126) to a distributing end (127, 227, 1127), and is surrounded by the host medium (128, 228, 1128) along the extension, wherein the transmitting end (123, 223) of the concentrating element (121, 221, 1121) is directly coupled to the receiving end (126, 226, 1126) of the waveguide (125, 225, 1125), the waveguide (125, 225, 1125) being configured to receive the light from the concentrating element (121, 221, 1121) at the receiving end (126, 226, 1126), wherein the waveguide (125, 225, 1125) and the host medium (128, 228, 1128) are configured to propagate the light to form a light pattern at the distributing end (127, 227, 1127), wherein a distribution of the light pattern across an area in the waveguide (125, 225, 1125) and the host medium (128, 228, 1128) at the distributing end (127, 227, 1127) is dependent on wavelength of the light;
a plurality of light sensitive elements (114, 214, 1114) arranged such that different light sensitive elements (114, 214, 1114) of the plurality of light sensitive elements (114, 214, 1114) receive different portions of the light pattern at the distributing end (127, 227, 1127) for wavelength dependent detection of light.

2. The device (100, 200, 1100) according to claim 1, wherein the light sensitive elements (114, 214, 1114) are arranged in a planar fashion in a detection plane,
wherein the device (100, 200, 1100) further comprises a symmetry axis extending through a center of the detection plane, in a direction perpendicular to the detection plane, and
wherein the concentrating element (121, 221, 1121) and the waveguide (125, 225, 1125), respectively, are symmetrically arranged along the symmetry axis such that the concentrating element (121, 221, 1121), the waveguide (125, 225, 1125), and the plurality of light sensitive elements (114, 214, 1114) extend symmetrically from the symmetry axis in two orthogonal directions parallel to the detection plane.

3. The device (100, 200, 1100) according to claim 2, wherein the waveguide (125, 225, 1125) and the host medium (128, 228, 1128) are configured to excite modes having a field distribution which is symmetrical with respect to the symmetry axis of the waveguide (125, 225, 1125).

4. The device (100, 200, 1100) according to any one of the preceding claims, wherein the waveguide (125, 225, 1125) and the host medium (128, 228, 1128) are further configured to propagate the light to form the light pattern at the distributing end (127, 227, 1127) such that the distribution of the light pattern across the area in the waveguide (125, 225, 1125) and the host medium (128, 228, 1128) at the distributing end (127, 227, 1127) is independent of polarization of the light.

5. The device (100, 200, 1100) according to any one of the preceding claims, wherein the concentrating element (121, 221, 1121) is configured to generate a photonic nano-jet for concentrating the light.

6. The device (100, 200, 1100) according to any one of the preceding claims, wherein the waveguide (125, 225, 1125) has a straight shape along the extension from the receiving end (126, 226, 1126) to the distributing end (127, 227, 1127), such that a cross-section of the receiving end (126, 226, 1126) and a cross-section of the distributing end (127, 227, 1127) are of equal size, or wherein the waveguide (125, 225, 1125) has a tapered shape along the extension from the receiving end (126, 226, 1126) to the distributing end (127, 227, 1127), such that a cross-section of the receiving end (126, 226, 1126) is larger than a cross-section of the distributing end (127, 227, 1127).

7. The device (100, 200, 1100) according to any one of the preceding claims, wherein a cross-sectional width of the receiving end (126, 226, 1126) and a cross-sectional width of the distributing end (127, 227, 1127), respectively, are not larger than 1 µm.

8. The device (200) according to any one of the preceding claims, further comprising a spacer element (231) arranged between the distributing end (227) and the plurality of light sensitive elements (214).

9. The device (200) according to claim 8, wherein the spacer element (231) is a slab waveguide.

10. The device (200) according to any one of the preceding claims, wherein the distributing end (227) is provided with an anti-reflection coating (240).

11. The device (200) according to any of the preceding claims, further comprising Deep Trench Isolation, DTI, (233) technology such that each respective light sensitive element (214) is confined by a trench preventing light incident onto the light sensitive element (214) from propagating to adjacent light sensitive elements (214).

12. The device (200) according to claim 11, when dependent on claim 8 or 9, wherein the DTI (233) is further arranged in the spacer element (231).

13. An imaging system (1000) for wavelength dependent imaging, the imaging system (1000) comprising an array of devices (1100) according to any one of the preceding claims.

14. The imaging system (1000) according to claim 13, wherein at least some of the light sensitive elements (1114) of the plurality of light sensitive elements (1114) in each device (1100) are shared between different devices (1100), such that at least some of the light sensitive elements (1114) are arranged to receive light from distributing ends (1127) of at least two adjacent devices (1100).

15. A method for wavelength dependent detection of light, the method comprising:
collecting (S502), by a concentrating element, light incident at a collecting end of the concentrating element;
concentrating (S504) the light at a transmitting end of the concentrating element;
receiving (S506), by a waveguide arranged in a host medium, the light from the concentrating element at a receiving end, wherein the waveguide is a multimode waveguide and forms an extension from the receiving end to a distributing end, and is surrounded by the host medium along the extension, and wherein the transmitting end of the concentrating element is directly coupled to the receiving end of the waveguide;
propagating (S508), by the waveguide and the host medium, the light to form a light pattern at the distributing end, wherein a distribution of the light pattern across an area in the waveguide and the host medium at the distributing end is dependent on wavelength of the light;
receiving (S510) different portions of the light pattern at the distributing end at different light sensitive elements of a plurality of light sensitive elements, for wavelength dependent detection of light.
